# EUROPEAN PATENT APPLICATION

(11) **EP 4 703 748 A1**
(43) Date of publication of application: **04.03.2026**
(21) Application number: 25193195.2
(22) Date of filing: 31.07.2025
(51) Int. Cl.: G01R 31/367, G01R 31/392, G06N 20/00

(54) **METHOD AND APPARATUS FOR PREDICTING LIFE OF BATTERY BY USING ARTIFICIAL INTELLIGENCE**

(30) Priority: 29.08.2024 KR 20240116481
(71) Applicant: SAMSUNG SDI CO., LTD., Yongin-si, Gyeonggi-do 17084 (KR)
(72) Inventor: KANG, Jeongmo, 17084 Yongin-si, Gyeonggi-do (KR); PARK, Kwanghum, 17084 Yongin-si, Gyeonggi-do (KR)
(74) Representative: Gulde & Partner

(57) **Abstract**

The apparatus for predicting a life of a battery by using an artificial intelligence model includes a memory storing at least one program and at least one processor configured to execute the at least one program to generate a combined vector by using subvectors derived from time series data and discrete data, which are related to charging and discharging of the battery, input, as input data, the generated combined vector to a battery life prediction model and determine whether a capacity prediction value of the battery, obtained as output data of the battery life prediction model, is less than or equal to a preset value, and derive a life prediction value for the battery in response to a result of determining that the capacity prediction value of the battery is less than or equal to the preset value.

## Description

### FIELD

The disclosure relates to a method and apparatus for predicting a life of a battery by using an artificial intelligence model.

### BACKGROUND

Unlike primary batteries that cannot be recharged, secondary batteries are batteries that are capable of being repeatedly charged and discharged. Low-capacity secondary batteries are used in small portable electronic devices, such as smartphones, feature phones, laptop computers, digital cameras, and camcorders, and large-capacity secondary batteries are widely used as motor driving power supply and power storage batteries for hybrid vehicles, electric vehicles, and the like. Such a secondary battery generally includes an electrode assembly including a positive electrode and a negative electrode, a case accommodating the electrode assembly, and an electrode terminal connected to the electrode assembly.

The information described in the background of the disclosure is only intended to improve understanding of the background of the disclosure and therefore may include information that does not constitute related or prior art.

### SUMMARY

Aspects of embodiments in the present disclosure provide a method and apparatus for predicting a life of a battery by using an artificial intelligence model. Some embodiments also provide a computer-readable recording medium having recorded thereon a program for executing the method on a computer.

Additional aspects will be set forth in part in the description which follows and, in part, will be apparent from the description, or may be learned by practice of the presented embodiments of the disclosure.

According to some embodiments, a method of predicting a life of a battery by using a battery life prediction model, which is an artificial intelligence model includes generating a combined vector by using a first subvector derived from time series data and a second subvector derived from discrete data, the time series data and the discrete data being related to charging and discharging of the battery. The method may also include inputting, as input data, the generated combined vector to the battery life prediction model and determining whether a capacity prediction value for the battery, obtained as output data of the battery life prediction model, is less than or equal to a preset value, and deriving a life prediction value for the battery in response to a result of determining that the capacity prediction value for the battery is less than or equal to the preset value.

According to some embodiments, an apparatus for predicting a life of a battery by using a battery life prediction model, which is an artificial intelligence model, includes a memory storing at least one program and at least one processor configured to execute the at least one program. Executing the at least one program using the at least one processor may implement generating a combined vector by using a first subvector derived from time series data and a second subvector derived from discrete data, the time series data and the discrete data being related to charging and discharging of the battery. The executing may also implement inputting, as input data, the generated combined vector to the battery life prediction model to determine whether a capacity prediction value for the battery, obtained as output data of the battery life prediction model, is less than or equal to a preset value, and deriving a life prediction value for the battery in response to a result of determining that the capacity prediction value for the battery is less than or equal to the preset value..

According to some embodiments, a non-transitory computer-readable recording medium has recorded thereon a program for executing the control method on a computer.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a diagram illustrating exemplary aspects of a method of predicting a life of a battery by using an artificial intelligence model, according to some embodiments;
FIG. 2 is a block diagram illustrating an example of an apparatus for predicting a life of a battery by using an artificial intelligence model, according to some embodiments;
FIG. 3 is a flowchart of an example of a method of predicting a life of a battery by using an artificial intelligence model, according to some embodiments;
FIG. 4 illustrates an exemplary flow of training a battery life prediction model, according to some embodiments;
FIG. 5 illustrates an example of data for training a battery life prediction model, according to some embodiments;
FIG. 6 is a diagram illustrating an example of a method of generating a combined vector, according to some embodiments;
FIG. 7 is a diagram illustrating an example of a method of obtaining a life prediction value for a battery, according to some embodiments; and
FIG. 8 is a diagram illustrating an example of a method of deriving an influence degree on a battery life, according to some embodiments.

### DETAILED DESCRIPTION

Hereinafter, embodiments of the disclosure will be described in detail with reference to the accompanying drawings. Terms or words used in the present specification and claims should not be interpreted as being limited to their usual or dictionary meanings, but should be interpreted as meanings and concepts that conform to the technical scope of the disclosure, based on the principle that an inventor may appropriately define the concepts of the terms in order to explain his or her own invention in the best way. Accordingly, embodiments described in the present specification and configurations illustrated in the drawings are merely some embodiments of the disclosure and do not represent all of the technical scope of the disclosure, and thus, it should be understood that there may be various equivalents and modifications that may augment or replace the embodiments at the time of filing the present application without straying from the scope of this disclosure.

Also, when used in the present specification, the terms "comprise/include" and/or "comprising/including" specify the presence of stated features, numbers, steps, operations, members, elements, and/or groups thereof, but do not preclude the presence or addition of one or more other features, numbers, operations, members, elements, and/or groups thereof. When describing embodiments of the disclosure, the term "may" or "may be" may include "one or more embodiments of the disclosure".

In addition, to help understanding of the disclosure, the attached drawings are not illustrated according to an actual scale, and dimensions of some components may be exaggerated. Also, same reference numbers may be assigned to same components in different embodiments.

When two targets being compared are "the same", the targets may be "substantially the same". Being "substantially the same" may include a deviation that is considered low in the art, for example, a deviation within 5%. Also, uniformity of a parameter in a certain region may indicate uniformity from an average perspective.

Although the terms first, second, etc. are used to describe various components, these components are not limited by such terms. These terms are used only to distinguish one component from another, and unless otherwise specifically stated, it is to be understood that a first component may also be a second component.

Throughout the specification, unless otherwise specifically stated, each element may be singular or plural.

A configuration being arranged "above (or under)" a component or "on (or below)" a component may indicate not only that the configuration is in contact with a top surface (or a bottom surface) of the component, but also that another configuration may be arranged between the component and the configuration arranged on (or below) the component.

When it is described that a component is "connected", "coupled", or "accessed" to another component, the components may be directly connected or accessed to each other, but it should also be understood that another component may be "arranged" between the components or that each component may be "connected", "coupled", or "accessed" through another component. Also, when a portion is electrically coupled to another portion, the portions may be directly coupled to each other or the portions may be coupled to each other with another element therebetween.

Throughout the specification, "A and/or B" may indicate A, B, or A and B unless otherwise specified. In other words, "and/or" includes all or any combination of listed items. The expression "C to D" indicate C or more and D or less, unless otherwise specified.

The terms used in the present specification are for describing embodiments of the disclosure and are not intended to limit of the disclosure.

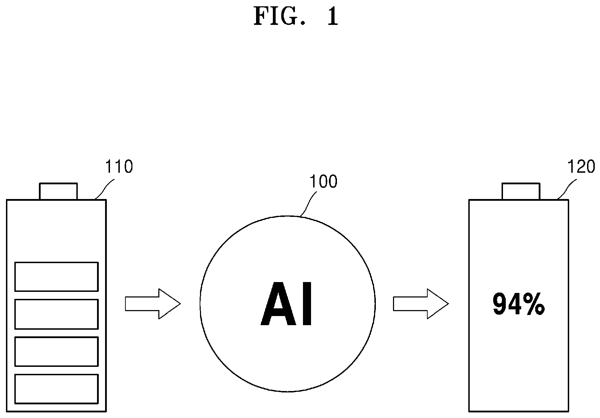

Hereinafter, the disclosure will be described in detail with reference to accompanying drawings. Specifically, a method of predicting a life of a battery by using an artificial intelligence model, according to some embodiments, will be described in more detail with reference to FIGS. 1 to 8. However, embodiments may be implemented in several different forms and are not limited to those described herein.

FIG. 1 is a diagram illustrating an example of a method of predicting a life of a battery 110 by using an artificial intelligence model 100, according to some embodiments.

Referring to FIG. 1, a user may obtain a life prediction value 120 of the battery 110 by using the artificial intelligence model 100.

For example, the user may input data related to charging and discharging of the battery 110 to the artificial intelligence model 100 to obtain the life prediction value 120. Here, the data related to the charging and discharging of the battery 110 may include, but is not limited to, parameters such as a driving pattern, a type of a charging and discharging pattern, capacity of the battery 110 before a charging and discharging cycle starts, capacity of the battery 110 after the charging and discharging cycle ends, an external temperature, and an idle time.

For example, the data related to the charging and discharging of the battery 110 described above may be divided into time series data and discrete data, and the time series data and discrete data may be preprocessed differently to generate input data for the artificial intelligence model 100.

Accordingly, the artificial intelligence model 100 may output the life prediction value 120 of the battery 110 based on the capacity of the battery 110 after the charging and discharging cycle ends. In addition, based on a certain algorithm of the artificial intelligence model 100, the extent to which each parameter included in the data related to the charging and discharging affects the life of the battery 110 may be derived.

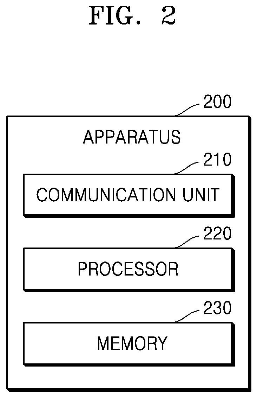

FIG. 2 is a block diagram illustrating an example of an apparatus 200 for predicting a life of a battery 110 by using an artificial intelligence model 100, according to some embodiments.

Referring to FIG. 2, the apparatus 200 for predicting a life of a battery by using an artificial intelligence model 100 may include a communication unit 210, a processor 220, and a memory 230. FIG. 2 generally illustrates components of the apparatus 200, which are related to exemplary embodiments. Thus, it would be obvious to one of ordinary skill in the art that the apparatus 200 may further include general-purpose components other than the components shown in FIG. 2.

The communication unit 210 may include one or more components enabling wired/wireless communication with an external server or an external device. For example, the communication unit 210 may include a short-range communication unit (not shown) and a mobile communication unit (not shown) for communication with an external server or external device.

The memory 230 may include hardware storing various types of data processed in the apparatus 200. The memory 230 may additionally include non-transitory computer-readable media that may store one or more programs for implementing processes and control when executed by the processor 220.

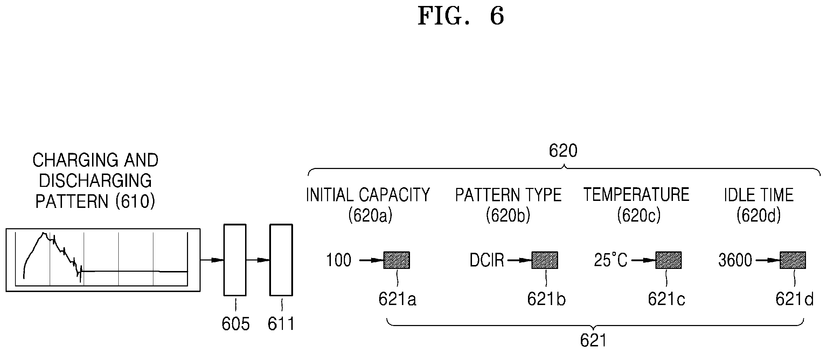

For example, various types of data, such as data related to charging and discharging of a battery, time series data 610 (FIG. 6), discrete data 620 (FIG. 6), a subvector value, a combined vector value, a capacity prediction value after a charging and discharging cycle of the battery ends, a life prediction value for the battery, and data generated according to an operation of the processor 220 may be stored in the memory 230. The memory 230 may also store an operating system (OS) and at least one program (e.g., a program required for the processor 220 to operate).

The memory 230 may include a random access memory (RAM) such as a dynamic random access memory (DRAM) or a static random access memory (SRAM), a read-only memory (ROM), an electrically erasable programmable read-only memory (EEPROM), CD-ROM, Blu-ray or another optical disk storage, a hard disk drive (HDD), a solid state drive (SSD), or a flash memory.

A processor 220 controls general operations of the apparatus 200. For example, the processor 220 may execute programs stored in the memory 230 to control an input unit (not shown), a display (not shown), the communication unit 210, and the memory 230, in general. Any reference to the processor 220 should be understood to refer to one or more processors, any one or more of which may implement each aspect of the methods discussed according to various embodiments.

The processor 220 may be realized by using at least one of an application-specific integrated circuit (ASIC), a digital signal processor (DSP), a digital signal processing device (DSPD), a programmable logic device (PLD), a field programmable gate array (FPGA), a controller, a microcontroller unit, a microprocessor, and electric units for performing other functions.

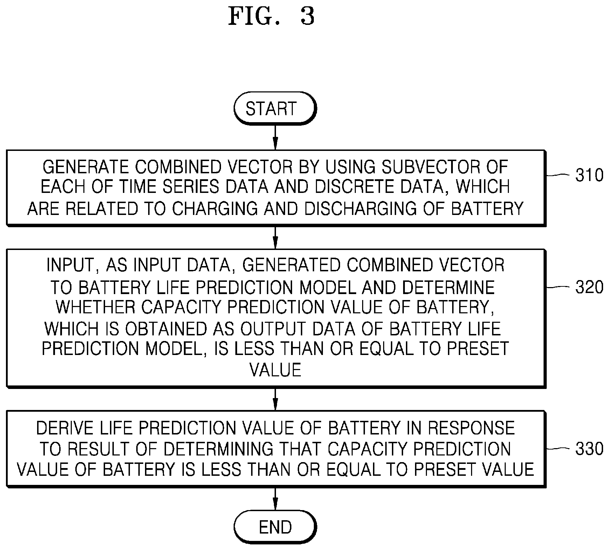

The processor 220 may execute the programs stored in the memory 230 to control operations of the apparatus 200. For example, the processor 220 may perform at least a portion of a method of predicting a life of a battery 110 by using an artificial intelligence model 100 according to embodiments, described with reference to FIGS. 3 to 8.

FIG. 3 is a flowchart of an example of a method of predicting a life of a battery 110 by using an artificial intelligence model 100, according to some embodiments.

Referring to FIG. 3, the method of predicting a life of a battery 110 by using an artificial intelligence model 100 may include operations 310 to 330. However, the method is not limited thereto, and general-purpose operations other than operations illustrated in FIG. 3 may be further included. Also, as described above with reference to FIGS. 1 and 2, at least one of operations of the flowchart illustrated in FIG. 3 may be implemented by a processor 220.

In operation 310, the processor 220 may generate a combined vector 630 by using a subvector 611, 621 of each of time series data 610 and discrete data 620, further discussed with reference to FIG. 6, which are related to charging and discharging of the battery 110.

For example, the processor 220 may input, as input data, a charging and discharging pattern (driving pattern) parameter included in the time series data 610 to a dimension reduction model, and obtain a first subvector 611 of a preset dimension as output data of the dimension reduction model. Also, the processor 220 may generate a second subvector 621 of a preset dimension by encoding and embedding at least one of a plurality of parameters included in the discrete data 620.

In operation 320, the processor 220 may input, as input data, the generated combined vector 630 to a battery life prediction model 100 and determine whether a capacity prediction value for the battery 110, obtained as output data of the battery life prediction model 100, is less than or equal to a preset value.

The battery life prediction model 100 may be a model trained by using experimental data, virtual data generated based on the experimental data, and simulation data. As a result, the reliability of the battery life prediction model is enhanced. Advantageously, the virtual data may be data generated by fine-tuning the experimental data by using a pre-trained tuning model.

In operation 330, a life prediction value for the battery 110 may be derived in response to a result of determining that the capacity prediction value for the battery 110 is less than or equal to the preset value.

For example, the processor 220 may obtain a number of driven times the battery life prediction model 100 has been driven until the capacity prediction value for the battery 110 is determined to be less than or equal to the preset value, and derive the life prediction value for the battery 110 based on the obtained number of driven times.

For example, the processor 220 may derive the battery life prediction value based on the number of driven times and a preset cycle parameter of the battery life prediction model 100.

Also, the processor 220 may derive an influence degree of at least one parameter included in the time series data 610 and the discrete data 620 on a battery life, based on the life prediction value for the battery 110. Here, the battery life prediction model 100 may be retrained by using at least one of the influence degree and the life prediction value for the battery 110.

For example, the processor 220 may derive the influence degree from the life prediction value for the battery 220, based on a parameter importance derivation algorithm of the battery life prediction model 100. Also, the processor 220 may determine a weight of each of a plurality of subvectors 611, 621 constituting the combined vector 630, based on the parameter importance derivation algorithm, and derive an influence degree of each of the plurality of subvectors 611, 621, based on the determined weight.

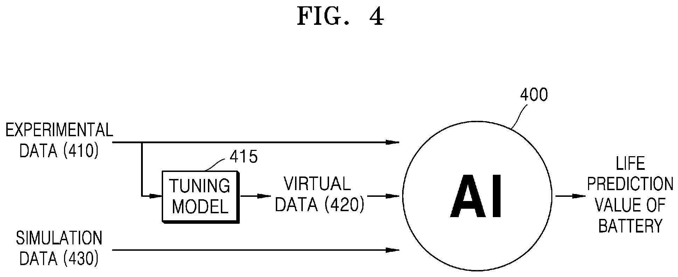

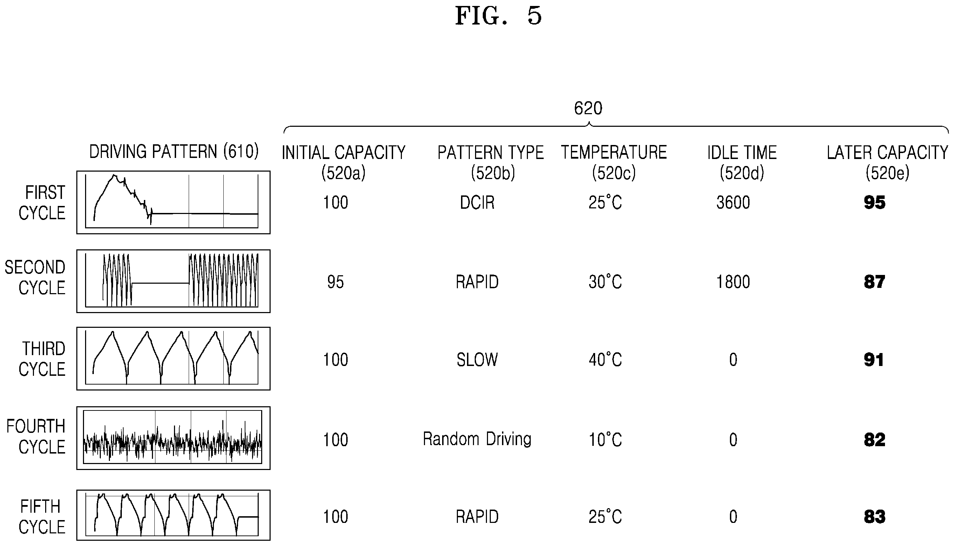

FIG. 4 illustrates an exemplary flow of training a battery life prediction model 100, according to some embodiments, and FIG. 5 illustrates an example of data for training a battery life prediction model 400, according to some embodiments. It should be understood that the label, battery life prediction model 400, is used for explanatory purposes to discuss the training aspect, but the result of the training is the battery life prediction model 100 discussed with reference to FIG. 1, for example.

Referring to FIG. 4, the processor may train the battery life prediction model 400 by using actual charging and discharging data and virtual charging and discharging data, thus improving the precision of the battery life prediction model 400.

For example, the processor may train the battery life prediction model 400 by using experimental data 410, virtual data 420 generated based on the experimental data 410, and simulation data 430. Here, the virtual data 420 may be data generated by fine-tuning the experimental data 410 by using a pre-trained tuning model 415.

For example, the experimental data 410 may be actual charging and discharging data obtained by actually performing a charging and discharging experiment on a battery 110, the virtual data 420 may be virtual charging and discharging data obtained as output data by inputting the experimental data 410 to the tuning model as input data, and the simulation data 430 may be data calculated based on electrochemical theory in an environment set similar to reality.

Here, the tuning model 415 may be a model for fine-tuning data. Accordingly, the processor may input, as the input data, the experimental data 410 to the tuning model and obtain the virtual data 420 as the output data.

For example, the virtual data 420 may be data obtained in an environment where parameters, such as a temperature, a driving pattern, and a charging and discharging time, are set to specific values, and the simulation data 430 may be data obtained in an environment where values of parameters, such as a temperature and a charging and discharging time, continuously change, as in an actual environment.

Accordingly, the processor 220 may train the battery life prediction model 400 by using various types of data.

Referring to FIG. 5, the processor 220 may learn data related to charging and discharging of a battery 110 by dividing the data into time series data 610 and discrete data 620 for each cycle, as further discussed with reference to FIG. 6.

For example, the processor 220 may learn the time series data 610 included in the data related to charging and discharging of the battery 110 by using a driving pattern 51 as input data. Here, the driving pattern 51 may include a pattern in which charging and discharging of the battery 110 are performed for one cycle or at least two cycles.

In another example, the processor 220 may learn an exemplary discrete data set 520 included in the data related to charging and discharging of the battery 110 by using, as input data, initial capacity 520a, a pattern type 520b, a temperature 520c, an idle time 520d, and later capacity 520e. Here, the initial capacity 520a may denote capacity of the battery 110 before one cycle of the driving pattern 51 starts, the pattern type 520b may be a parameter indicating whether a pattern of the driving pattern 51 is rapid, slow, direct current internal resistance (DCIR), or random, the temperature 520c may denote a temperature when the battery 110 is being charged and discharged, the idle time 520d may denote a time during which the battery 110 is being left without being charged or discharged, and the later capacity 520e may denote the capacity of the battery 110 after one cycle of the driving pattern 51 ends.

For example, the processor 220 may train a battery life prediction model 400 to obtain the later capacity 520e as output data by inputting, as input data, a parameter of the driving pattern 51 included in the time series data 610, and a parameter of the initial capacity 520a, a parameter of the pattern type 520b, a parameter of the temperature 520c, a parameter of the idle time 520d, and a parameter of the later capacity 520e, which are included in the discrete data set 520, to the battery life prediction model 400. As shown in FIG. 6, discrete data 620 used by the trained battery life prediction model 100 may not include the later capacity 520e that is part of the discrete data set 520.

Meanwhile, the processor 220 may obtain output data of a battery life prediction model 400 in a shorter time by preprocessing each of time series data 610 and discrete data 620. In other words, the processor 220 may generate new input data by preprocessing each of the time series data 610 and the discrete data 620, and predict a life of a battery 110 by using the generated input data.

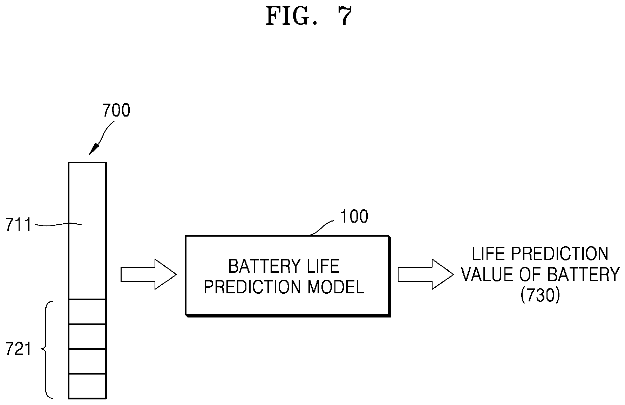

For example, the processor 220 may generate a combined vector 700 (FIG. 7) by using a subvector 611, 621 (more generally 711, 721, respectively, in FIG. 7) of each of the time series data 610 and the discrete data 620, which are related to charging and discharging of the battery 110. In other words, the processor 220 may generate a subvector 611, 621 of each of the time series data 610 and the discrete data 620, and generate one combined vector 700 by using the generated subvectors 611, 621. Here, the generated combined vector 700 may be used as input data of the battery life prediction model 400 (and, during operation, the battery life prediction model 100). Thus, as a significant advantage, computational resources, power consumption and computational time can be saved.

FIG. 6 is a diagram illustrating an example of a method of generating a combined vector 700, according to some embodiments.

First, referring to FIG. 6, the processor 220 may preprocess time series data 610 and discrete data 620 to generate a first subvector 611 and second subvector 621, respectively.

For example, the processor 220 may input, as input data, a parameter of a driving pattern 61 included in the time series data 610 to a dimension reduction model 605, and obtain the first subvector 611 of a preset dimension as output data of the dimension reduction model 605. Here, the dimension reduction model 605 may refer to an artificial intelligence model configured to convert multidimensional data into low-dimensional data while maintaining characteristics of the data.

The time series data 610 is multidimensional data that requires a lot of data processing time, and thus, the processor 220 may reduce a dimension of time series data to shorten the data processing time.

The processor 220 may generate the second subvector 621 of the preset dimension by encoding and embedding at least one of a plurality of parameters included in the discrete data 620. Here, the encoding may denote encoding or converting data according to set rules, and the embedding may denote vectorizing data.

Accordingly, the processor 220 may generate the second subvector 621 (second subvector components 621a, 621b, 621c, and 621d) by encoding and/or embedding parameters of initial capacity 620a, a pattern type 620b, a temperature 620c, and an idle time 620d, which are included in the discrete data 620, respectively.

The first subvector 611 and the second subvector 621 may be vectors of a same dimension. Accordingly, the processor 220 may combine the first subvector 611 and the second subvector 621 of the same dimension to generate one combined vector 700.

The processor may use the combined vector 700 as input data of a battery life prediction model 100 to obtain a battery life prediction value as output data.

FIG. 7 is a diagram illustrating an example of a method of obtaining a life prediction value 730 of a battery 110, according to some embodiments.

Referring to FIG. 7, the processor 220 may input, as input data, a combined vector 700 generated by using a first subvector 711 and second subvector 721 to a battery life prediction model 100 to obtain the life prediction value 730 of the battery 110 as output data.

The processor 220 may input the combined vector 700 as the input data to the battery life prediction model 100, determine whether a capacity prediction value for the battery 110, obtained as the output data, is less than or equal to a preset value, and derive the life prediction value 730 of the battery 110 in response to a result of determining that the capacity prediction value for the battery 110 is less than or equal to the preset value.

The processor 220 may obtain a number of driven times as a number of times the battery life prediction model 100 has been driven until the capacity prediction value for the battery 110 is determined to be less than or equal to the preset value, and derive the life prediction value 730 of the battery based on the obtained number of driven times.

The processor may input the combined vector 700 to the battery life prediction model 100 to obtain the capacity prediction value 730 of the battery 110. Here, the capacity prediction value 730 of the battery 110 may denote a value obtained by predicting capacity of the battery 110 after the battery 110 has been charged and discharged for a preset number of cycles. The preset number of cycles may denote the number of cycles in which the battery 110 is charged and discharged each time the battery life prediction model 100 is driven.

Accordingly, when the battery 110 is charged and discharged for the preset number of cycles, the capacity of the battery 110 may decrease compared to before the charging and discharging, and the processor 220 may predict a life of the battery 110 by predicting the capacity of the battery 110 after the battery 110 is charged and discharged for the preset number of cycles.

When the capacity prediction value for the battery 110, obtained as the output data, exceeds the preset value, the processor 220 may use the obtained capacity prediction value 730 of the battery 110 again as input data for the battery life prediction model 100.

For example, when the preset value is 80 and 90 is obtained as first output data of the battery life prediction model 100, the processor 220 may use 90 as input data for the battery life prediction model 100. The processor 220 may generate the combined vector 700 in which an initial capacity parameter included in discrete data is 90, and may use the generated combined vector 700 as input data for the battery life prediction model 100. Also, the processor 220 may drive the battery life prediction model 100 until (n)th output data of the battery life prediction model 100 is 80 or less, wherein n is a natural number equal to or greater than 1.

For example, the processor 220 may repeatedly perform such processes to obtain the number of driven times the battery life prediction model 100 has been driven until the capacity prediction value 730 of the battery 110 is determined to be less than or equal to the preset value 80, according to the example.

When the (n)th output data of the battery life prediction model is 80 or less, the processor 220 may obtain n times as the number of driven times of the battery life prediction model 100.

For example, when the preset number of cycles of the battery life prediction model 100 is 10 cycles and third output data is 80 or less, the processor 220 may obtain a time for performing 30 cycles as the life prediction value 730 of the battery 110. The life prediction value 730 of the battery 110 may be obtained not only in the form of time, but also in another form such as the number of cycles, percentage (%), battery capacity, or the like.

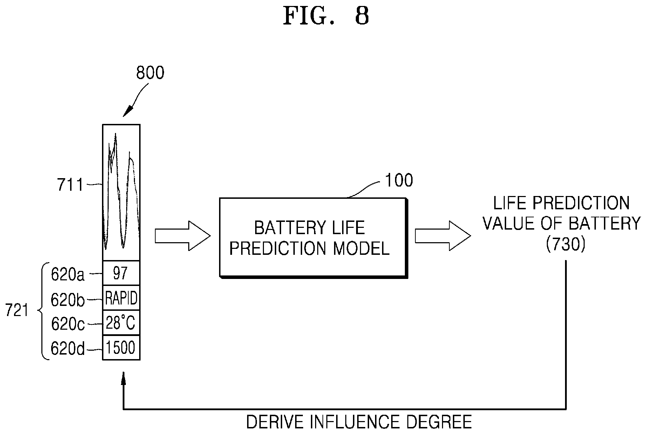

FIG. 8 is a diagram illustrating an example of a method of deriving an influence degree on a battery life, representing weightings used in the battery life prediction model 100, according to some embodiments.

Referring to FIG. 8, the processor 220 may derive an influence degree of each of a plurality of parameters included in a combined vector 700 on a life prediction value 730 of a battery 110.

For example, the processor 220 may derive an influence degree of at least one parameter included in time series data 610 and discrete data 620 on a battery life, based on the life prediction value 730 of the battery 110.

For example, the processor 220 may determine a weight for each of a plurality of subvectors 711 and 721 that configure the combined vector 700, by using an algorithm for deriving importance of a parameter according to a change in a prediction value of an artificial intelligence model.

For example, the algorithm for deriving importance of a parameter according to a change in a prediction value of an artificial intelligence model may include an attention mechanism. Here, the attention mechanism may be a mechanism of obtaining more accurate output data by assigning a weight to a parameter, among input data, which affects output data and paying attention to an important parameter.

In another example, the algorithm for deriving importance of a parameter according to a change in a prediction value of an artificial intelligence model may include a local interpretable model-agnostic explanation (LIME) algorithm. Here, the LIME algorithm may denote an algorithm for providing a prediction value or an interpretation value for a parameter of an artificial intelligence model according to a prediction value of the artificial intelligence model.

For example, the processor may derive the influence degree from the life prediction value 730 of the battery 110, based on a parameter importance derivation algorithm according to a change in a prediction value of an artificial intelligence model (the battery life prediction model 100). The processor 220 may determine the weight for each of the plurality of subvectors 711 and 721 constituting the combined vector 700, based on the parameter importance derivation algorithm, and derive an influence degree of each of the subvectors 711 and 721, based on the determined weight. The second subvector 721 may include multiple components corresponding to multiple components (e.g., 620a, 620b, 620c, 620d, as shown for example) associated with multiple parameters making up the discrete data 620.

For example, the processor may derive the degrees to which the plurality of subvectors 711 and 721 affect a life of the battery 110 by obtaining the life prediction value 730 of the battery 110 by varying a combination of a first subvector 711 and second subvector 721.

For example, when the life prediction value 730 of the battery 110 is 30 cycles, the processor 220 may derive an influence degree of a temperature parameter greater than an influence degree of an initial capacity parameter if a life prediction value 730 obtained excluding the initial capacity parameter component 620a is 29 cycles and a life prediction value 730 obtained excluding the temperature parameter component 620c is 33 cycles. In other words, the processor 220 may derive the influence degree of each parameter on the battery life by deriving a life prediction value 730 after assigning a weight to each parameter. In the example above, life prediction value 730 is derived after assigning a weight of zero to the initial capacity parameter and the temperature parameter, in turn, to determine their relative influence degree. However, the method of deriving a life prediction value 730 is not limited thereto.

Accordingly, the processor 220 may perform the above operations to derive the influence degree of each of the plurality of parameters included in the time series data 610 and the discrete data 620.

Also, the battery life prediction model 100 may be retrained by using at least one of the influence degree and the life prediction value 730 of the battery 110.

For example, the processor 220 may retrain the battery life prediction model 100 to more accurately predict the life of the battery 110 by assigning a weight to a parameter with a high influence degree on the life of the battery 110.

According to some embodiments of the disclosure, an arbitrary driving pattern generated by using an artificial intelligence model may be used as training data.

Also, a time required to derive a life prediction value 730 of a battery 110 may be reduced by preprocessing data related to charging and discharging of the battery 110.

In addition, the artificial intelligence model may be used to derive a parameter that affects a life of the battery 110.

However, effects that are obtained through the disclosure are not limited to the effects described above, and other technical effects that not mentioned will be clearly understood by one of ordinary skill in the art from the description of the disclosure.

The above-described methods may be implemented via a program executable on a computer, and may be implemented in a general-purpose digital computer operating a program using a computer-readable recording medium. In addition, a structure of data used in the above-described methods may be recorded on a computer-readable medium through various methods. Examples of the computer-readable medium include storage media such as magnetic storage media (for example, read-only memory (ROM), random-access memory (RAM), universal serial bus (USB), floppy disks, and hard disks), and optical readable media (for example, CD-ROM and DVD).

One of ordinary skill in the art will understand that the disclosure may be implemented in a modified form without departing from the essential features of the disclosure. Therefore, the disclosed methods should be considered from an explanatory perspective rather than a limited perspective, and the scope of rights is exhibited in the claims and their equivalents, rather than in the above description, and should be interpreted to include all differences within the equivalent scope.

## Claims

1. A method of predicting a life of a battery (110) by using a battery life prediction model (400), which is an artificial intelligence model (100), the method comprising:
generating a combined vector (630, 700) by using a first subvector (611, 711) derived from time series data (610) and a second subvector (621, 721) derived from discrete data (620), the time series data (610) and the discrete data (620) being related to charging and discharging of the battery (110);
inputting, as input data, the generated combined vector (630, 700) to the battery life prediction model (400) and determining whether a capacity prediction value for the battery (110), obtained as output data of the battery life prediction model (400), is less than or equal to a preset value; and
deriving a life prediction value for the battery (110) in response to a result of determining that the capacity prediction value for the battery (110) is less than or equal to the preset value.

2. The method of claim 1, wherein the battery life prediction model (400) is a model (100) trained by using experimental data (410), virtual data (420) generated based on the experimental data (410), and simulation data (430).

3. The method of claim 1 or 2, wherein the generating comprises:
inputting, as input data, a driving pattern (51, 61) parameter included in the time series data (610) to a dimension reduction model (605); and
obtaining the first subvector (611, 711) of a preset dimension as output data of the dimension reduction model (605).

4. The method of claims 1 to 3, wherein the deriving comprises:
obtaining, as a number of driven times, a number of times the battery life prediction model (400) has been driven until the capacity prediction value for the battery (110) is determined to be less than or equal to the preset value; and
deriving the life prediction value for the battery (110) based on the number of driven times.

5. The method of claims 1 to 4, further comprising deriving an influence degree of at least one parameter included in the time series data (610) and the discrete data (620) on a battery (110) life, based on the life prediction value for the battery (110).

6. The method of claim 5, wherein the battery life prediction model (400) is retrained by using at least one of the influence degree and the life prediction value for the battery (110).

7. The method of claim 5 or 6, wherein the deriving the influence degree is from the life prediction value for the battery (110), based on a parameter importance derivation algorithm of the battery life prediction model (400).

8. A non-transitory computer-readable recording medium having recorded thereon a program for causing a computer to execute the method of claims 1 to 7.

9. An apparatus (200) for predicting a life of a battery (110) by using a battery life prediction model (400), which is an artificial intelligence model (100), the apparatus (200) comprising:
a memory (230) storing at least one program; and
at least one processor configured to execute the at least one program to:
generate a combined vector (630, 700) by using a first subvector (611, 711) derived from time series data (610) and a second subvector (621, 721) derived from discrete data (620), the time series data (610) and the discrete data (620) being related to charging and discharging of the battery (110);
input, as input data, the generated combined vector (630, 700) to a battery life prediction model (400) and determine whether a capacity prediction value for the battery (110), obtained as output data of the battery life prediction model (400), is less than or equal to a preset value; and
derive a life prediction value for the battery (110) in response to a result of determining that the capacity prediction value for the battery (110) is less than or equal to the preset value.

10. The apparatus (200) of claim 9, wherein the battery life prediction model (400) is a model (100) trained by using experimental data (410), virtual data (420) generated based on the experimental data (410), and simulation data (430).

11. The apparatus (200) of claim 9 or 10, wherein the at least one processor is further configured to execute the at least one program to input, as input data, a driving pattern (51, 61) parameter included in the time series data (610) to a dimension reduction model (605), and obtain the first subvector (611, 711) of a preset dimension as output data of the dimension reduction model (605).

12. The apparatus (200) of claims 9 to 11, wherein the at least one processor is further configured to execute the at least one program to obtain, as a number of driven times, a number of times the battery life prediction model (400) has been driven until the capacity prediction value for the battery (110) is determined to be less than or equal to the preset value, and derive the life prediction value for the battery (110) based on the number of driven times.

13. The apparatus (200) of claims 9 to 12, wherein the at least one processor is further configured to execute the at least one program to derive an influence degree of at least one parameter included in the time series data (610) and the discrete data (620) on a battery (110) life, based on the life prediction value for the battery (110).

14. The apparatus (200) of claim 13, wherein the battery life prediction model (400) is retrained by using at least one of the influence degree and the life prediction value for the battery (110).

15. The apparatus (200) of claim 13 or 14, wherein the at least one processor is further configured to execute the at least one program to derive the influence degree from the life prediction value for the battery (110), based on a parameter importance derivation algorithm of the battery life prediction model (400).
